# EUROPEAN PATENT APPLICATION

(11) **EP 1 505 642 A2**
(43) Date of publication of application: **09.02.2005**
(21) Application number: 04002925.8
(22) Date of filing: 10.02.2004
(51) Int. Cl.: H01L 21/3213, H01L 21/311, H01L 21/00, H01L 21/768, B08B 3/00

(54) **Method and apparatus for manufacturing semiconductor devices**

(30) Priority: 08.08.2003 KR 2003055012
(71) Applicant: Dongbu Electronics Co., Ltd., Seoul 135-523 (KR)
(72) Inventor: Nam, Sang Woo, Heungdeok-gu, Cheongju-si 361-709 (KR); Lee, Chea Gab, No.102-1101 Ganam maeul Apt., Yeoju-gun 469-881 Gyeonggi-do (KR)
(74) Representative: Appelt, Christian W.

(57) **Abstract**

A method and an apparatus for cleaning (e.g., removing etch by-products from) an etched target are disclosed. The method comprises providing a cleaning solution at a predetermined temperature lower than room temperature and cleaning the etched target with the cleaning solution. The apparatus for cleaning semiconductor devices comprises a chuck on which a semiconductor substrate is mounted; a solution storage part for storing a cleaning solution; a solution supply part for supplying the semiconductor substrate with the cleaning solution; a heat exchange part for maintaining the cleaning solution at a temperature lower than room temperature; and a control part for controlling the chuck rotation for a predetermined time and the cleaning solution delivery from the heat exchange part to the semiconductor substrate via the solution supply part. Accordingly, the present invention provides a more precise lateral profile of an etched pattern from the etch by-product cleaning process.

## Description

### BACKGROUND OF THE INVENTION

### Field of the Invention

The present invention relates to a method of manufacturing semiconductor devices and, more particularly, to a method of cleaning and/or preventing defects in a semiconductor device due to etch by-products generated while etching an etch target.

### Background of the Related Art

In the conventional fabrication of semiconductor devices, an etch target such as silicon oxide (SiO₂), silicon nitride (SiN), or a metal layer (e.g., Al alloy, W, Cu, etc.) is deposited over a semiconductor substrate. Then, a photoresist pattern is formed on the etch target by photolithography. A desired pattern is etched using the photoresist mask by dry etching, and the photoresist mask is removed. Thereafter, etch by-products such as polymers are removed by means of an organic solvent or an appropriate solution prior to further processing.

Conventionally, the etch by-products are removed by a spin spray processing or a bath processing. In the spin spray processing, the semiconductor substrate rotates with a fixed speed in a process chamber and a solution is sprayed over the semiconductor substrate in order to remove the etch by-products. In the bath processing, the semiconductor substrate is immersed in a solution for an appropriate time to remove the etch by-products. At present, the spin spray processing is more broadly used than the bath processing because the former can remove more rapidly the etch by-products compared to the latter.

In pursuit of high integration and miniaturization in fabricating integrated circuits, line widths and pitches in a semiconductor device are gradually reduced and interconnect wiring is formed as a multi-layer structure. However, in the fabrication of highly integrated semiconductor devices, e.g., interconnects, a dry etch process can leave etch by-products, e.g., polymers, on the sides of device structures, for example, interconnects. The polymers need to be thoroughly cleaned to avoid defects in interconnects. Conventionally, the cleaning process to remove the polymers is performed at room temperature (typically, about 25°C). Thus, if the polymer cleaning process is conducted for a long time in order to remove the polymer thoroughly, sides of the interconnects may be attacked by the solution to remove the polymer and, therefore, precise lateral profiles of the interconnects cannot be obtained.

Korean Patent Publication No. 2002-19650, to Nam and Kwak, discloses a method for cleaning and rinsing organic solvents and etch by-products from an etched metal layer in order to avoid defects in a metal interconnect pattern. Here, the cleaning agent is an organic solvent and the rinsing agent is cool water with a temperature between 0°C and 15°C. However, the above-mentioned published patent publication discloses avoiding defects generated during a photoresist removing process after anisotropic etching of the metal interconnects using an etching gas including a fluorine ion. In addition, the above-mentioned published patent complicates semiconductor fabrication processes by separating the cleaning process using an organic solvent and the rinsing process using water.

U.S. Patent No. 6,194,326, to Gilton, discloses a low temperature rinse of etching agents. In the above-mentioned U.S. patent, a method is provided for rinsing etchants and etch by-products from a semiconductor substrate assembly using a fluid at a temperature lower than 0°C. However, the above-mentioned U.S. patent discloses rinsing etchants and organic residues in contact holes and vias.

### SUMMARY OF THE INVENTION

Accordingly, the present invention is directed to a method and an apparatus for manufacturing semiconductor devices that substantially overcome one or more problems due to limitations and disadvantages of the background art.

An object of the present invention is to provide a method for manufacturing semiconductor devices, which can provide a precise lateral profile of an etched pattern by removing etch by-products using a solution at a temperature lower than room temperature and that allows a large deviation range for the removal time.

Another object of the present invention is to provide an apparatus for cleaning semiconductor devices which can reduce attacks against sidewalls of a pattern during removal of etch by-products, equipped with a heat exchange part for maintaining a cleaning solution at low temperature.

Additional advantages, objects, and features of the present invention will be set forth in part in the description which follows and which will become apparent to those having ordinary skill in the art upon examination of the following or which may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a method for manufacturing or cleaning semiconductor devices having an etched pattern of lines or trenches thereon or therein according to the present invention comprises the steps of cooling a cleaning solution to a temperature lower than room temperature and supplying the cooled cleaning solution to the semiconductor devices to remove etch by-products from the semiconductor devices.

In addition, an apparatus for manufacturing semiconductor devices according to the present invention comprises:
a chuck on which a semiconductor substrate having an etched pattern is mounted;
a solution storage part for storing a cleaning solution;
a solution supply part for supplying the cleaning solution to the semiconductor substrate;
a heat exchange part for maintaining the cleaning solution at a temperature lower than ambient or room temperature; and
a control part for controlling the chuck so that the chuck rotates for a predetermined time and that the cooled cleaning solution is supplied from the solution storage part to the semiconductor substrate mounted on the chuck via the solution supply part.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. In the drawings;

Fig. 1 is a block diagram of an apparatus for manufacturing a semiconductor device according to the present invention;

Fig. 2 is a flow chart, illustrating a method of controlling an apparatus according to the present invention;

Fig. 3 is a flow chart, illustrating a process for manufacturing a semiconductor device according to the present invention;

Figs. 4a through 4c are schematic cross-sectional views, illustrating a interconnection process in fabricating a semiconductor device, in accordance with a preferred embodiment of the present invention;

Figs. 5a through 5f are schematic cross-sectional views, illustrating a contact electrode formation process in fabricating a semiconductor device, in accordance with another preferred embodiment of the present invention; and

Figs. 6a and 6b are SEM pictures, illustrating interconnects attacked by a cleaning solution and normal interconnects after an etch by-product cleaning process at various temperatures.

### DETAILED DESCRIPTION OF THE PREFERRED EMBODIMENT

Reference will now be made in detail to the preferred embodiments of the present invention, examples of which are illustrated in the accompanying drawings.

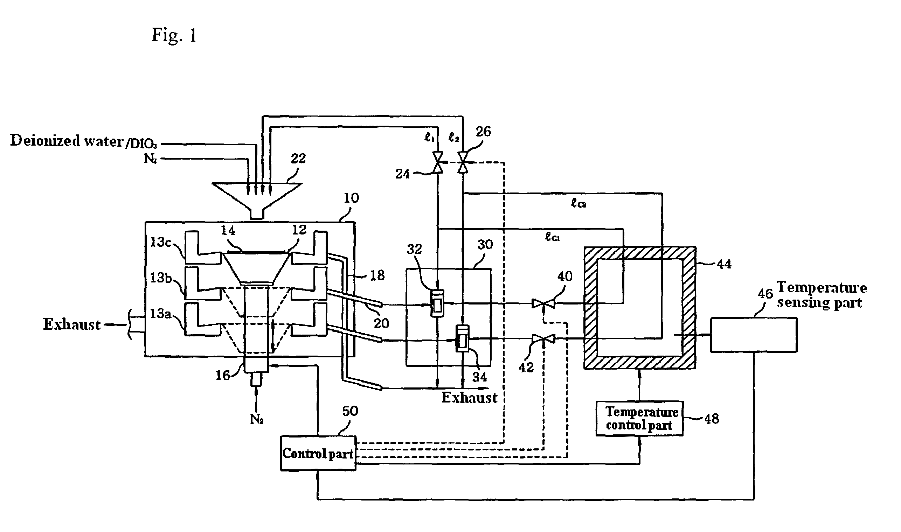

Fig. 1 schematically shows an apparatus for fabricating a semiconductor device according to the present invention. Referring to Fig. 1, the apparatus of the present invention comprises a process chamber 10, a solution storage part 30, a solution supply part comprising at least one of supply lines ℓ1 and ℓ2, a heat exchange part 44, at least one of circulation lines ℓc1 and ℓc2, and a control part 50.

The process chamber 10 comprises a spin chuck 12 for affixing a semiconductor substrate 14 and a motor drive part for rotating the spin chuck with a predetermined RPM (revolutions per minute). Generally, semiconductor substrate 14 has an etched pattern on its surface, preferably a pattern of metal lines or trenches in an insulator layer (which may further comprise vias or contact holes). Under the spin chuck 12, an inert gas such as N₂ is supplied to the backside of semiconductor substrate 14. Collecting basins 13a, 13b, and 13c are positioned around the spin chuck 12 to prevent cleaning solution from being splashed outside. The solution in the collecting basins 13a, 13b, and 13c is sent to the solution storage part 30 through a recovery line 20, or are discharged from the apparatus through discharge lines 18. An outlet member 22, positioned over the semiconductor substrate 14, sprays or supplies the cleaning solution onto the semiconductor substrate. N₂, an inert gas, is supplied into the process chamber 10 and exhausted from the process chamber 10 through an exhaust pipe.

The solution storage part 30 comprises one or more storage containers 32 and 34. The storage containers store a solution for cleaning (e.g., removing etch by-products from) the semiconductor substrate. The solution may be, for example, a mixture consisting of DI water (deionized water) or ozone water (DI water with dissolved O₃, or DIO₃), alone or in combination with sulfuric acid (H₂SO₄), hydrogen peroxide (H₂O₂), and/or hydrofluoric acid (HF). Each of storage containers 32 and 34 is connected to each of the supply lines ℓ1 and ℓ2 to deliver the cleaning solution to the process chamber 10 and each of the circulation lines ℓc1 and ℓc2 to deliver the cleaning solution to the heat exchange part 44. In addition, the storage part 30 is connected to the discharge line 18 to discharge the cleaning solution which has been used for an appropriate time from the apparatus.

Each of the supply lines ℓ1 and ℓ2 supplies the semiconductor substrate 14 mounted on the spin chuck 12 in the process chamber 10 with the cleaning solution stored in the solution storage part 30. The supply lines ℓ1 and ℓ2 may have first valves 24 and 26, respectively. The first valves 24 and 26 are used to allow (ON or OPEN) or block (OFF or CLOSED) the supply of the cleaning solution from the solution storage part 30 to the process chamber 10. One end of each of the circulation lines ℓc1 and ℓc2 is connected to the solution storage part 30 and the other end thereof is connected to a position on each of the supply lines ℓ1 and ℓ2 between each of the first valves 24 and 26 and the solution storage part 30.

Second valves 40 and 42 are positioned on the circulation lines ℓc1 and ℓc2, respectively. The second valves 40 and 42 are used to allow (ON or OPEN) or block (OFF or CLOSED) the circulation of the cleaning solution through the heat exchange part 44 to the storage containers 32 and 34 in the solution storage part 30.

Opening and/or closing the first valves 24 and 26 and the second valves 40 and 42 is controlled by the control part 50. When the etch by-product cleaning process is not being conducted in the process chamber 10, the control part 50 closes (OFF) the first valves 24 and 26 and opens (ON) the second valves 40 and 42. Therefore, the cleaning solution in the solution storage part 30 circulates through the heat exchange part 44, and the temperature of the cleaning solution is maintained at a predetermined temperature lower than ambient or room temperature, preferably lower than 20°C, and more preferably between -20°C and 20°C.

On the other hand, while the cleaning process is being conducted in the process chamber 10, the control part 50 opens (ON) the first valves 24 and 26 and closes (OFF) the second valves 40 and 42. Therefore, the cleaning solution maintained at a temperature lower than 20°C by the heat exchange part 44 is delivered to the process chamber 10 through the supply lines ℓ1 and ℓ2 and is sprayed or supplied onto the semiconductor substrate 14 mounted on the spin chuck 12.

The etch by-product cleaning process in the process chamber 10 is conducted for between several seconds (e.g., 3, 5 or 10 seconds) and several minutes (e.g., 2, 3 or 5 minutes). In addition, the control part 50 may be configured to allow the semiconductor substrate 14 mounted on the spin chuck 12 to rotate at a predetermined RPM by operating or controlling the motor drive part 16 of the spin chuck 12.

The heat exchange part 44 of the present invention may comprise a temperature control part 48 including a cooling part (not shown) and a heater (not shown). The cooling part and the heater are installed on the circulation lines ℓc1 and ℓc2 so as to raise or lower temperature of cleaning solution in the circulation lines ℓc1 and ℓc2. The cooling part of the temperature control part 48 comprises at least a cooling pipe and a cooler. The cooling pipe lowers temperature of the cleaning solution flowing through the circulation lines ℓc1 and ℓc2, using a refrigerant. The cooler compresses, expands, vaporizes, and condenses the refrigerant flowing through the cooling pipes.

The apparatus for manufacturing a semiconductor device according to the present invention may further comprise a temperature sensing part 46 that measures the temperature of the cooling pipes or the refrigerant and transmits information regarding the measured temperature to the control part 50. If the temperature measured is different from the predetermined temperature, the control part 50 operates the cooling part or the heater in the temperature control part 48 in order to lower or raise the temperature of the refrigerant in the heat exchange part 44 so that the refrigerant is maintained at a temperature lower than 20°C. The temperature control by the heat exchange part 44 is generally performed while the process chamber 10 is not in operation.

The apparatus for manufacturing a semiconductor device according to the present invention may comprise a plurality of chambers each equipped with a spin sprayer. In addition, the apparatus may include a bath processing apparatus instead of or in addition to a spin spray processing apparatus.

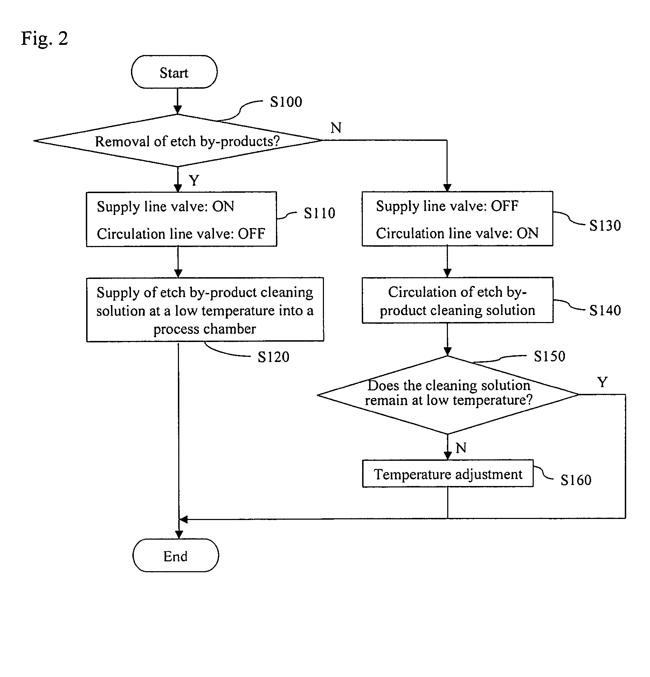

Fig. 2 is a flow chart, illustrating a method of controlling an apparatus according to the present invention. Referring to Figs. 1 and 2, the control part 50 determines whether an etch by-product cleaning process is being conducted in the process chamber 10 or another chamber (S100).

If the cleaning process is being conducted, the control part 50 generates an ON signal to open the first valves 24 and 26 positioned on the supply lines ℓ1 and ℓ2 and an OFF signal to close the second valves 40 and 42 positioned on the circulation lines ℓc1 and ℓc2 (S110). Subsequently, the cleaning solution stored in the solution storage part 30 (for example, a mixture or solution of sulfuric acid (H₂SO₄), hydrogen peroxide (H₂O₂), hydrofluoric acid (HF), and DI water or ozone water) is delivered to the outlet member 22 over the process chamber 10 through the supply lines ℓ1 and ℓ2. Here, the cleaning solution is maintained at a temperature lower than 20°C, preferably between -20°C and 20°C, by the heat exchange part 44 (S120).

The outlet member 22 sprays or otherwise supplies the cleaning solution onto the semiconductor substrate 14 mounted on the spin chuck 12 which rotates at a predetermined RPM by the motor drive part 16. The cleaning process to remove etch by-products is conducted for a period of time of from several seconds to several minutes.

The etch by-products may be polymers, non-polymeric particles (e.g., metal, oxide or nitride particles) and/or etch residues. The cleaning solution at a temperature between -20°C and 20°C can remove the etch by-products with relatively little attack on an etched pattern on or in the semiconductor substrate, compared to the same cleaning solution at room temperature (e.g., about 25°C) because the rate of oxide or metal etching by the cleaning solution decreases with lower temperature.

If the cleaning process has not been started or has been completed, the control part 50 generates and/or maintains an OFF signal to close the first valves 24 and 26 positioned on the supply lines ℓ1 and ℓ2 and an ON signal to open the second valves 40 and 42 positioned on the circulation lines ℓc1 and ℓc2 (S130). If the cleaning process has been completed, the cleaning solution in the collecting basins 13a, 13b, and 13c is delivered to the solution storage part 30 through the recovery line 18. If the cleaning process has not been started, the cleaning solution is not delivered from the process chamber 10 to the solution storage part 30.

According to the signals OFF for the first valves and ON for the second valves, the cleaning solution in the solution storage part 30 is delivered to the heat exchange part 44 through the circulation lines ℓc1 and ℓc2 rather than the process chamber 10 (S140). In the heat exchange part, the cleaning solution is maintained at a temperature lower than 20°C by the refrigerant in the heat exchange part 44 because the refrigerant is also maintained at a temperature lower than 20°C, preferably between -20°C and 20°C.

The cleaning solution at a temperature lower than 20°C returns to the storage containers 32 and 34 in the solution storage part 30. Thus, when the cleaning solution is not delivered to the process chamber 10, the cleaning solution in the solution storage part 30 may be continuously maintained at a temperature lower than 20°C by being delivered to the heat exchange part 44 through the circulation lines ℓc1 and ℓc2.

After the step S140, the control part 50 gets information from the temperature sensing part 46 about temperature of the refrigerant or the cooling pipes in the heat exchange part 44. The control part 50 checks whether the temperature measured is maintained between -20°C and 20°C (S150). If the temperature measured is higher than 20°C, the control part 50 allows the cooling part in the temperature control part 48 to work in order to lower temperature of the refrigerant in the heat exchange 44 to a value between -20°C and 20°C. If the temperature measured is lower than -20°C, the control part 50 allows the heater in the temperature control part 48 to work in order to raise temperature of the refrigerant to a value between -20°C and 20°C (S160). In one embodiment, control part 50 checks whether the measured temperature is at a predetermined temperature (+ 1°C or +2 °C) between -20°C and 20°C.

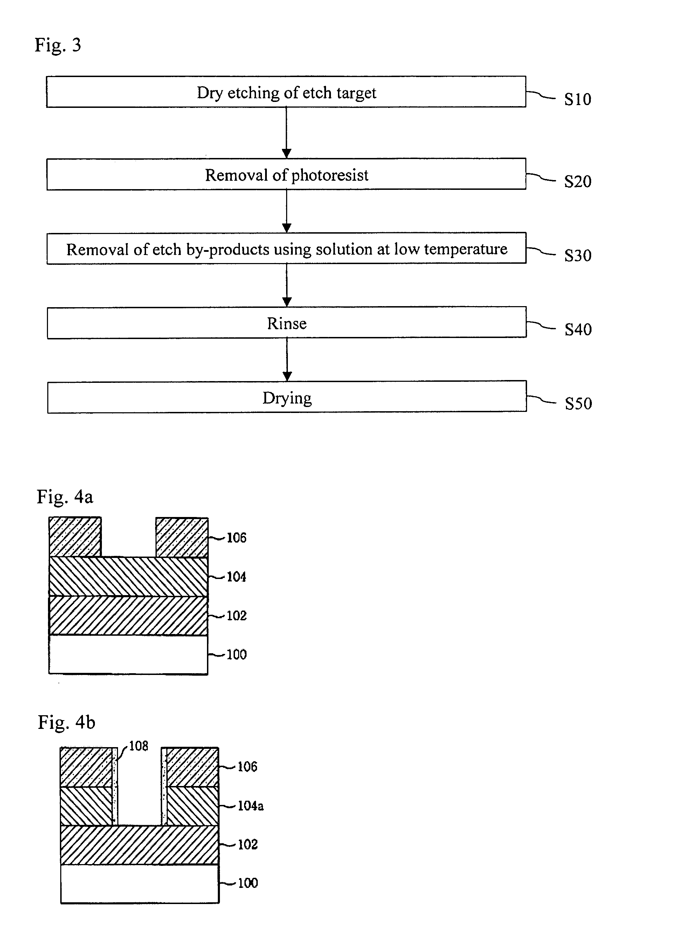

Fig. 3 is a flow chart, illustrating a process for manufacturing a semiconductor device (and more particularly, etching and cleaning a semiconductor device) according to the present invention. The etch by-product cleaning process according to the present invention is applicable to the manufacturing processes of any semiconductor device.

Now, a preferred embodiment of a semiconductor device manufacturing process to which the present invention may be applied is described. First, a target layer is formed over a semiconductor substrate and a photoresist pattern is formed over the target layer. A desired pattern is etched through the photoresist pattern by dry etching (S10). After the photoresist pattern is removed, a cleaning solution for removing etch by-products (which may be diluted with DI water or ozone water [DI O₃]) is delivered to a process chamber in order to remove etch by-products such as polymers on the etched pattern (S20∼S30). The cleaning solution is maintained at a low temperature, preferably between -20°C and 20°C. Next, the semiconductor substrate is rinsed (e.g., with DI water) and dried (S40∼S50). Here, the target layer may be a semiconductor substrate, an insulating layer, a dielectric layer, a conducting layer or a metal layer. These layers may be a single layer or a multi-layer. Particularly, the metal layer may be a metal or an alloy thereof such as aluminum, an aluminum alloy, copper and/or a copper alloy. In addition, the metal layer may be a silicide metal layer such as TiSi or WSi, or a barrier metal layer such as Ti/TiN or TaN.

The invention also concerns an etch by-product cleaning process in fabrication of interconnects and contact electrodes. Figs. 4a through 4c are schematic cross-sectional views, illustrating an interconnection process in fabricating a semiconductor device, in accordance with a preferred embodiment of the present invention. Referring to Fig. 4a, an insulating layer 102 such as USG (undoped silicate glass), PSG (phosphorus doped silicate glass), FSG (fluorosilicate glass) or BPSG (boron phosphorus silicate glass) is formed over a semiconductor substrate 100 and a metal layer 104 such as aluminum is deposited on the insulating layer. Next, a photoresist pattern 106 is formed on the metal layer by photolithography. Referring to Fig. 4b, part of the metal layer 104 is etched through the photoresist pattern 106 by dry etching such as a plasma etch to leave a metal layer pattern 104a. Here, etch by-products 108 such as polymers may be formed on sidewalls of the photoresist pattern 106 and the metal layer pattern 104a.

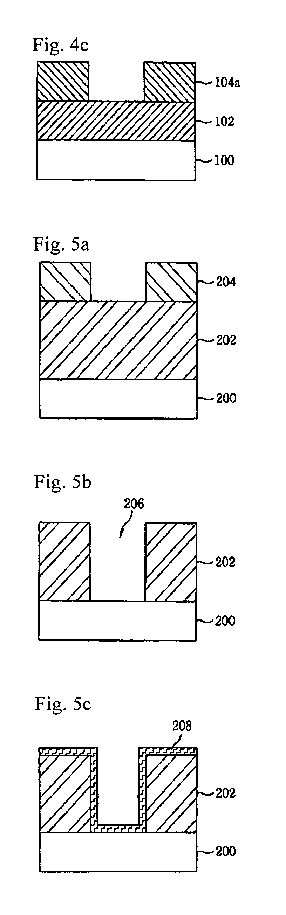

Referring to Fig. 4c, the photoresist pattern is removed and the semiconductor substrate having the metal layer pattern 104a is loaded in the process chamber 10 as shown in Fig. 1. Then, a cleaning solution at a temperature between -20°C and 20°C is delivered to the outlet member 22 above the process chamber 10 through the supply lines ℓ1 and ℓ2. The cleaning solution is preferably a mixture of sulfuric acid (H₂SO₄), hydrogen peroxide (H₂O₂), hydrofluoric acid (HF), and DI water/ozone water (DI O₃). The outlet member 22 sprays or supplies the cleaning solution onto the semiconductor substrate for preferably between several seconds and several minutes while the substrate is spinning in order to remove the etch by-products. Here, the semiconductor substrate 14 is mounted on the spin chuck 12 and rotated at a predetermined RPM by the motor drive part 16. In this interconnection process, a lateral profile of the metal layer pattern 104a is substantially protected from chemical attack by the cleaning solution because the cleaning solution is maintained at a low temperature between -20°C and 20°C, and in certain embodiments between 0°C and 20°C, between 10°C and 20°C, or from about 12°C to about 18°C, to reduce or inhibit over-etching of the sidewalls of the metal layer pattern 104a.

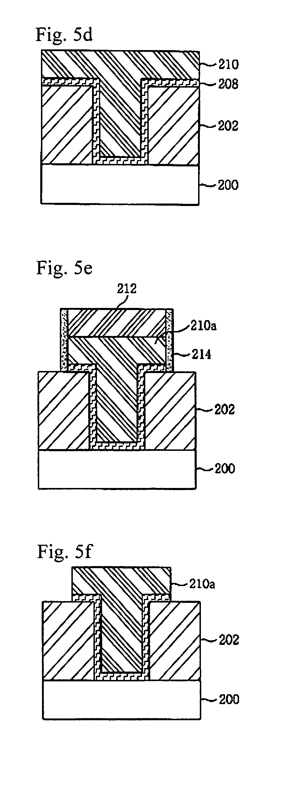

Figs. 5a through 5f are schematic cross-sectional views, illustrating a contact electrode formation process in fabricating a semiconductor device, in accordance with another preferred embodiment of the present invention. Referring to Fig. 5a, an insulating layer 202 such as USG, PSG, FSG and/or BPSG is formed over a semiconductor substrate 100 and a photoresist pattern 204 is formed over the insulating layer 202 by photolithography. Referring to Fig. 5b, a contact hole 206 is patterned through the photoresist pattern 204 and etched to expose an active region in the substrate. Referring to Fig. 5c, a barrier metal layer 208 such as Ti or TiN is deposited over the insulating layer 202 and on sidewalls and bottom of the contact hole 206. In one embodiment, the barrier metal layer 208 comprises a layer of Ti onto which a layer of TiN is formed. Referring to Fig. 5d, a conductive plug 210 such as tungsten fills the contact hole and is deposited over the barrier metal layer. Referring to Fig. 5e, a second photoresist pattern 212 is formed over the conductive plug 210 by photolithography. Then, a contact electrode 210a is formed by dry etching the conductive plug 210 and the barrier metal layer 208 through the second photoresist pattern 212. As a result of the dry etching, etch by-products 214 such as polymers may be formed on sidewalls of the photoresist pattern 212 and the contact electrode 210a. Referring to Fig. 5f, the photoresist pattern 212 is removed and the semiconductor substrate having a contact electrode 210a is loaded in the process chamber 10 as shown in Fig. 1. Then, the outlet member 22 sprays or supplies the cleaning solution at a temperature between -20°C and 20°C onto the semiconductor substrate rotating at a predetermined RPM for preferably between several seconds and several minutes in order to remove the etch by-products from the semiconductor substrate. In this contact electrode formation process, a lateral profile of the contact electrode 210a is substantially protected from chemical attack by the cleaning solution because the cleaning solution is maintained at a low temperature between -20°C and 20°C, thereby reducing or inhibiting over-etching of the sidewalls of the contact electrode.

The present invention is applicable to a via electrode fabrication process as well as the above-mentioned metal interconnect and contact electrode fabrication processes.

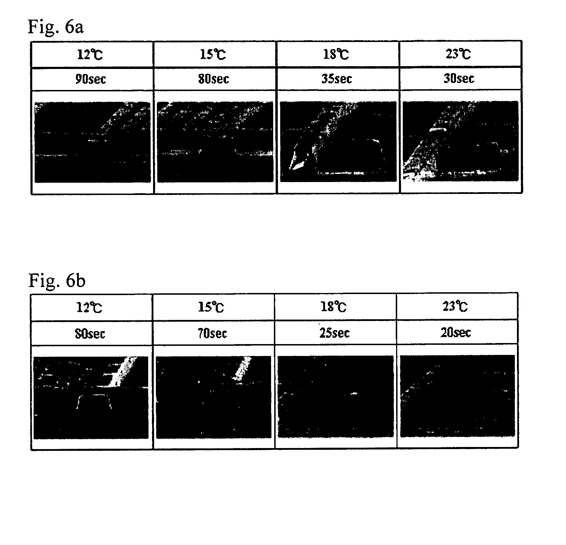

Figs. 6a and 6b are SEM pictures, illustrating wires attacked by a cleaning solution and normal wires after an etch by-product cleaning process.

Fig. 6a shows SEM pictures of metal interconnects when the etch by-product cleaning process is conducted for 90 seconds at 12°C (a), for 80 seconds at 15°C (b), for 35 seconds at 18°C (c), and for 30 seconds at 23°C (d), respectively. As shown in Fig. 6a, the metal interconnects in cases (a), (b), and (c) show better lateral profiles compared to case (d).

Fig. 6b shows SEM pictures of metal interconnects when the etch by-product cleaning process is conducted for 80 seconds at 12°C, for 70 seconds at 15°C, for 25 seconds at 18°C, and for 20 seconds at 23°C, respectively.

As shown Figs. 6a and 6b, a cleaning solution with a temperature lower than 20°C provides a more precise lateral profile of an etched pattern while removing etch by-products from the etched pattern compared to a cleaning solution with a temperature higher than 20°C. This is because the cleaning solution at a temperature lower than 20°C has a relatively slow rate of etching reaction compared to the same cleaning solution at a temperature higher than 20°C.

Accordingly, the present invention can provide more precise lateral profiles after etching of interconnects, contact/via electrodes, etc., by cleaning etch by-products with a cleaning solution at a temperature lower than room temperature. Therefore, the present invention can greatly improve reliability and yields of devices by reducing defects due to etch by-products and/or due to over-etched lateral profiles of device patterns. In addition, the present invention can ensure a more commercially advantageous process time margin by allowing a large deviation range for cleaning (e.g., etch by-product removal) time.

The foregoing embodiments are merely exemplary and are not to be construed as limiting the present invention. The present teachings can be readily applied to other types of apparatuses. The description of the present invention is intended to be illustrative, and not to limit the scope of the claims. Many alternatives, modifications, and variations will be apparent to those skilled in the art.

## Claims

1. A method for cleaning a semiconductor substrate having an etched pattern of lines or trenches thereon or therein, comprising the steps of:
(a) cooling a cleaning solution to a predetermined temperature lower than ambient or room temperature; and
(b) supplying the cooled cleaning solution to the semiconductor substrate to remove etch by-products from the pattern of lines or trenches.

2. The method as defined by claim 1, wherein the cleaning solution comprises hydrofluoric acid (HF).

3. The method as defined by claim 1, wherein the cleaning solution comprises a mixture of deionized water and a member selected from the groups consisting of sulfuric acid (H₂SO₄), hydrogen peroxide (H₂O₂), and hydrofluoric acid (HF).

4. The method as defined by claim 1, wherein the predetermined temperature is a temperature lower than 20°C.

5. The method as defined by claim 4, wherein the predetermined temperature is a temperature of between 0°C and 20°C.

6. The method as defined by claim 5, wherein the predetermined temperature is a temperature of between 10°C and 20°C.

7. The method as defined by claim 1, wherein the cleaning step comprises rotating the semiconductor substrate for between several seconds and several minutes, while delivering the cleaning solution to the rotating semiconductor substrate.

8. The method as defined by claim 1, wherein the etched pattern is formed from or in a member selected from the group consisting of a semiconductor substrate, an insulating layer, a dielectric layer, a conducting layer, and a metal layer.

9. The method as defined by claim 8, wherein the etched pattern comprises a single layer of material.

10. The method as defined by claim 8, wherein the etched pattern comprises a multi-layer structure.

11. The method as defined by claim 8, wherein the etched pattern comprises a conductor selected from the group consisting of aluminum, an aluminum alloy, copper, a copper alloy, a metal silicide layer, and a barrier metal layer.

12. A method for cleaning a semiconductor substrate having an etched metal pattern thereon, comprising the steps of:
(a) cooling an aqueous cleaning solution to a predetermined temperature lower than ambient or room temperature; and
(b) cleaning the semiconductor substrate with the aqueous cleaning solution.

13. The method as defined by claim 12, wherein the aqueous cleaning solution comprises a mixture of deionized water and a member selected from the groups consisting of sulfuric acid (H₂SO₄), hydrogen peroxide (H₂O₂), and hydrofluoric acid (HF).

14. The method as defined by claim 13, wherein the predetermined temperature is a temperature of between 0°C and 20°C.

15. The method as defined by claim 14, wherein the predetermined temperature is a temperature of between 10°C and 20°C.

16. The method as defined by claim 12, wherein the etched pattern comprises a single layer of material.

17. The method as defined by claim 12, wherein the etched pattern comprises a multi-layer structure.

18. The method as defined by claim 12, wherein the etched metal pattern comprises a conductor selected from the group consisting of aluminum, an aluminum alloy, copper, a copper alloy, tungsten, a metal silicide layer, and a barrier metal layer.

19. An apparatus for cleaning a semiconductor substrate, comprising:
(a) a chuck on which a semiconductor substrate having an etched pattern is mounted;
(b) a solution storage part for storing a cleaning solution;
(c) a solution supply part for supplying the cleaning solution to the semiconductor substrate;
(d) a heat exchange part for maintaining the cleaning solution at a temperature lower than ambient or room temperature; and
(e) a control part for controlling (i) the chuck so that said chuck rotates for a predetermined time and (ii) said solution supply part and said heat exchange part so that the cleaning solution supplied from the solution supply part to the semiconductor substrate is cooled by the heat exchange part.

20. The apparatus as defined by claim 19, wherein the heat exchange part comprises:
(a) a first valve installed on the solution supply part;
(b) a circulation line having one end connected to the solution storage part and the other end connected to the solution supply part between the first valve and the solution storage part;
(c) a second valve installed on the circulation line; and
(d) a cooling part installed on the circulation line for lowering a temperature of the cleaning solution inside the circulation line.

21. The apparatus as defined by claim 20, wherein the cooling part comprises:
(a) a cooling pipe configured to exchange heat with the circulation line, the cooling pipe having a refrigerant therein; and
(b) a cooler for compressing, expanding, vaporizing, and condensing the refrigerant in the cooling pipe.

22. The apparatus as defined by claim 19, wherein the heat exchange part further comprises:
(a) a heater for raising a temperature of the cleaning solution inside the circulation line; and
(b) a temperature sensing part for measuring the temperature of the cleaning solution inside the circulation line.

23. The apparatus as defined by claim 19, wherein the control part controls (i) the chuck so that said chuck rotates for a sufficient time to remove etch by-products on the semiconductor substrate, (ii) the first valve and the second valve to maintain the cleaning solution in the solution storage part at said temperature and/or to supply the cleaning solution to the semiconductor substrate through the solution supply part.

24. The apparatus as defined by claim 22, further comprising a temperature sensing part in communication with the control part, wherein said control part is configured to control the heater or the cooling part to maintain the cleaning solution at the temperature.

25. The apparatus as defined by claim 19, wherein the predetermined temperature is a temperature lower than 20°C.
